(19) Europäisches Patentamt / European Patent Office / Office européen des brevets

(11) **EP 1 735 978 B1**

(12) **FASCICULE DE BREVET EUROPEEN**

(45) Date de publication et mention de la délivrance du brevet:
**01.06.2016 Bulletin 2016/22**

(21) Numéro de dépôt: **05753748.2**

(22) Date de dépôt: **11.04.2005**

(51) Int Cl.:
*H04L 25/02* (2006.01)    *H04B 7/005* (2006.01)

(86) Numéro de dépôt international:
**PCT/FR2005/000872**

(87) Numéro de publication internationale:
**WO 2005/104473 (03.11.2005 Gazette 2005/44)**

(54) **PROCEDE POUR INVERSER TEMPORELLEMENT UNE ONDE**

VERFAHREN ZUR ZEITLICHEN UMKEHR EINER WELLE

METHOD FOR TEMPORAL INVERSION OF A WAVE

(84) Etats contractants désignés:
**AT BE BG CH CY CZ DE DK EE ES FI FR GB GR HU IE IS IT LI LT LU MC NL PL PT RO SE SI SK TR**

(30) Priorité: **13.04.2004 FR 0403845**

(43) Date de publication de la demande:
**27.12.2006 Bulletin 2006/52**

(73) Titulaires:
• **Centre National de la Recherche Scientifique (CNRS)**
  **75794 Paris Cedex 16 (FR)**
• **Université Paris 7 - Denis Diderot**
  **75251 Paris Cedex 05 (FR)**

(72) Inventeurs:
• **FINK, Mathias**
  **F-92190 Meudon (FR)**
• **LEROSEY, Geoffroy**
  **F-75013 Paris (FR)**
• **DERODE, Arnaud**
  **F-75013 Paris (FR)**
• **DE ROSNY, Julien**
  **F-75012 Paris (FR)**
• **TOURIN, Arnaud**
  **F-92310 Sevres (FR)**

(74) Mandataire: **Cabinet Plasseraud**
  **66, rue de la Chaussée d'Antin**
  **75440 Paris Cedex 09 (FR)**

(56) Documents cités:
**US-A1- 2003 138 053    US-A1- 2004 014 498**

• **GOMES J ET AL: "Asymmetric underwater acoustic communication using a time-reversal mirror" IEEE, vol. 3, 11 septembre 2000 (2000-09-11), pages 1847-1851, XP010521142**

**Description**

La présente invention est relative aux procédés pour inverser temporellement des ondes.

Plus particulièrement, l'invention concerne un procédé pour inverser temporellement une onde correspondant à au moins un signal initial s (t) où t est le temps, ce signal initial s(t) présentant une certaine fréquence centrale f0 et une bande passante Δf, procédé dans lequel on détermine un signal d'inversion temporel α.s(-t), où α est un coefficient multiplicatif constant ou variable dans le temps et s(-t) est l'inversion temporelle de s(t).

Le document EP-A-0 803 991 décrit un exemple d'un tel procédé, qui présente l'inconvénient de faire appel à des approximations de l'inversion temporelle de certains signaux, ce qui ne fonctionne que dans certaines conditions particulières, notamment lorsque la bande passante est très étroite.

La présente invention a notamment pour but de pallier cet inconvénient.

Le document US 2004/014498 décrit une méthode pour transmettre des signaux dans laquelle la station de base effectue une conjugaison de phase (inversion temporelle) d'une onde reçue du terminal pour émettre vers le terminal.

Le document US 2003/138053 décrit un système pour transmettre un signal dans un canal, en effectuant une inversion temporelle du signal.

A cet effet, selon l'invention, un procédé du genre en question est caractérisé en ce qu'il comporte les étapes suivantes :

- on applique au signal initial s(t) une première transformation adaptée pour abaisser la fréquence centrale du signal et pour sensiblement ne pas entraîner de perte d'information par rapport au signal initial, ladite première transformation produisant un premier ensemble de signaux transformés comprenant au moins un premier signal transformé Ki(t) de plus faible fréquence centrale que le signal initial, ledit premier ensemble de signaux transformés Ki(t) étant représentatif dudit signal initial s(t),
- on applique à chaque premier signal transformé Ki(t), une deuxième transformation produisant un deuxième signal transformé K'i(t) sensiblement de même fréquence centrale que le premier signal transformé, ladite deuxième transformation produisant ainsi un deuxième ensemble de signaux transformés K'i(t) à partir du premier ensemble de signaux transformés Ki(t), ladite deuxième transformation étant choisie pour que ledit deuxième ensemble de signaux transformés soit représentatif du signal d'inversion temporel s(-t),
- on applique au deuxième ensemble de signaux transformés K'i(t) une troisième transformation qui génère le signal d'inversion temporel α.s(-t).

Grâce à ces dispositions, on parvient à produire une onde inversée temporellement sans avoir à travailler à la fréquence f0, ce qui, en mode numérique, nécessiterait d'échantillonner le signal à une fréquence d'échantillonnage au moins égale à deux fois la fréquence maximale du signal s(t) et impliquerait donc l'utilisation de matériels relativement coûteux, notamment si la fréquence f0 est élevée. Au contraire, selon l'invention, on tire parti du fait que la bande passante Δf du signal s(t) est inférieure à f0 pour ramener ledit signal à une plus faible fréquence sans perte d'information, ce qui est généralement possible par une opération simple et standard, par exemple de type démodulation. Le ou les signaux Ki(t) de plus faible fréquence peuvent alors être échantillonnés et traités pour obtenir le ou les signaux K'i(t) représentatifs de s(-t), avec une électronique fonctionnant à relativement faible fréquence et donc peu coûteuse. Par une opération standard par exemple de type modulation (par exemple l'opération inverse de celle appliquée initialement au signal s(t)), on revient ensuite à plus haute fréquence en recréant le signal s(-t).

Dans des modes de réalisation préférés de l'invention, on peut éventuellement avoir recours en outre à l'une et/ou à l'autre des dispositions suivantes :

- la bande passante Δf est inférieure à f0 ;
- la troisième transformation est une transformation inverse de la première transformation ;
- la première transformation est une démodulation adaptée pour éliminer un signal de porteuse de fréquence f0 pour extraire ledit premier ensemble de signaux transformés Ki(t)du signal initial s(t), et la troisième transformation est une modulation d'un signal porteur de fréquence f0 par le ou les signaux K'i(t) ;
- la première transformation est une démodulation IQ produisant deux premiers signaux transformés K1(t)=I(t) et K2(t)=Q(t) tels que $s(t) = I(t)\cos(2\pi.f0.t) + Q(t)\sin(2\pi.f0.t)$, la deuxième transformation transforme le signal K1(t) en K'1(t)=I(-t) et le signal K2(t) en K'2(t)=-Q(-t), et la troisième transformation est une modulation IQ inverse de ladite démodulation ;
- la première transformation est une démodulation en amplitude et phase produisant deux premiers signaux transformés K1(t)=A(t), et K2(t)=φ(t), où A(t) est l'amplitude du signal s(t) et φ(t) la phase du signal s(t), la deuxième transformation transforme le signal K1(t) en K'1(t)=A(-t) et le signal K2(t) en K'2(t)=-φ(-t), et la troisième transformation est une modulation inverse de ladite démodulation, produisant le signal d'inversion temporelle s(-t)=A(-t)cos[2π.f0.t-φ(-t)];

- la première transformation est un sous échantillonnage, avec une fréquence d'échantillonnage inférieure à 2f0 mais au moins égale à 2Δf, produisant un seul signal transformé K1(t), la deuxième transformation est une inversion temporelle transformant le signal K1(t) en K'1(t)=K1(-t), et la troisième transformation est un filtrage de bande passante sensiblement égale à Δf et centrée sur f0, transformant K'1(t) en s(-t) ;
- la première transformation est un décalage en fréquence vers le bas, en bande intermédiaire, produisant un seul premier signal transformé K1(t), la deuxième transformation est une inversion temporelle transformant le signal K1(t) en K'1(t)=K1(-t), et la troisième transformation est un décalage en fréquence vers le haut, inverse dudit décalage en fréquence vers le bas ;
- les première et troisième transformations sont réalisées sur des signaux analogiques, chaque premier signal transformé subit un échantillonnage et la deuxième transformation est réalisée numériquement avant de convertir chaque deuxième signal transformé en signal analogique ;
- l'échantillonnage est réalisé à une fréquence d'échantillonnage inférieure à la fréquence centrale f0 ;
- l'onde est électromagnétique (par exemple une onde radio, voire une onde optique) ;
- la fréquence centrale f0 est comprise entre 0,7 et 50 GHz ;
- la fréquence centrale f0 est comprise entre 0,7 et 10 GHz ;
- l'onde est choisie parmi les ondes acoustiques et les ondes élastiques.

D'autres caractéristiques et avantages de l'invention apparaîtront au cours de la description suivante d'une de ses formes de réalisation, donnée à titre d'exemple non limitatif, en regard des dessins joints.

Sur les dessins :

- la figure 1 est un schéma de principe représentant un exemple de dispositif d'émission/réception d'ondes permettant de mettre en oeuvre un procédé selon une forme de réalisation de l'invention,
- et les figures 2 et 3 illustrent une application particulière du dispositif de la figure 1.

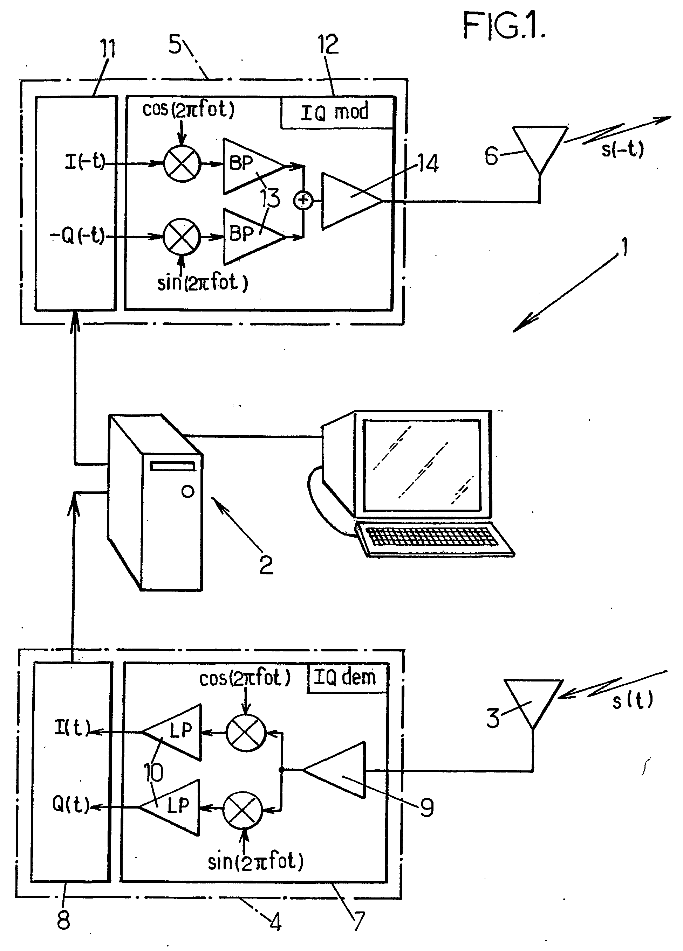

La figure 1 représente un exemple de dispositif d'émission et de réception d'ondes, en l'occurrence des ondes électromagnétiques radio, permettant de capter une onde et de l'inverser temporellement.

A cet effet, le dispositif 1 d'émission et de réception d'ondes représenté sur la figure 1 comporte par exemple :

- une unité centrale électronique 2, par exemple un micro-ordinateur ou un circuit électronique à microprocesseur(s),
- une antenne de réception 3 d'ondes radio, adaptée pour capter un signal initial s(t) correspondant à une onde électromagnétique, où t représente le temps,
- un ensemble démodulateur 4 recevant le signal s(t) initial capté par l'antenne de réception 3 et relié à l'unité centrale électronique 2 pour lui transmettre des signaux démodulés,
- un ensemble modulateur 5 relié à l'unité centrale électronique 2 pour recevoir de cette unité centrale des signaux démodulés représentatifs de l'inversion temporelle s(-t) du signal initial s(t),
- et une antenne émettrice 6 reliée à l'ensemble modulateur 5 pour émettre une onde électromagnétique correspondant au signal modulé $\alpha$.s(-t), où s(-t) est l'inversion temporelle du signal initial s(t) et $\alpha$ est un coefficient multiplicatif, constant ou variable dans le temps.

Tous ces éléments peuvent, le cas échéant, être compris dans un même appareil électronique tel qu'un radiotéléphone, une base fixe radiotéléphonique, ou autre.

Le signal initial s(t) présente une certaine fréquence centrale f0 et une bande passante Δf inférieure à f0, par exemple inférieure à f0/2 (généralement Δf est petite par rapport f0).

Le signal initial s(t) peut s'écrire en notation réelle : s(-t)=A(-t)cos[2$\pi$.f0.t+$\varphi$(-t)], où A(t) est l'amplitude du signal s(t) et $\varphi$ (t) sa phase.

Le signal s(t) est donc, de façon générale, un signal modulé en amplitude et phase à partir d'une onde porteuse de fréquence f0, cette fréquence f0 étant généralement connue à l'avance.

Dans l'exemple représenté sur la figure 1, l'ensemble démodulateur 4 comprend un démodulateur IQ 7 qui applique une première transformation au signal s(t) pour générer deux premiers signaux transformés K1(t) = I(t) et K2(t) = Q(t) correspondant respectivement à la modulation en phase et en quadrature du signal. En notation réelle, ces signaux I(t), Q(t) sont tels que :

$$s(t) = I(t) \cos (2\pi.f0.t) + Q(t) \sin (2\pi.f0.t).$$

Ces signaux I(t), Q(t) sont fournis par le démodulateur IQ 7 à un convertisseur analogique digital 8 qui échantillonne lesdits signaux et les transmet sous forme numérique à l'unité centrale 2.

Pour générer les signaux I(t), Q(t), le démodulateur IQ 7 peut par exemple comporter un amplificateur 9 qui reçoit le signal s(t) de l'antenne 3 et qui alimente deux circuits parallèles :

- un premier circuit dans lequel le signal s (t) est multiplié par un signal $\cos(2\pi.f0.t)$ et dans lequel le résultat de la multiplication est transmis à un filtre passe-bas 10 en sortie duquel se retrouve le signal I(t),
- et un deuxième circuit dans lequel le signal s(t) est multiplié avec un signal $\sin(2\pi.f0.t)$ et dans lequel le résultat de cette multiplication est transmis à un filtre passe-bas 10 en sortie duquel se retrouve le signal Q(t).

A partir des signaux I(t), Q(t) échantillonnés, l'unité centrale 2 applique aux signaux une deuxième transformation permettant d'obtenir des deuxièmes signaux transformés K'1(t) = I-(-t) et K'2(t) = -Q(-t).

Ces signaux K'1(t), K'2(t) sont transmis sous forme numérique par l'unité centrale 2, en temps réel ou en temps différé, à l'ensemble modulateur 5, et ledit ensemble modulateur applique à ces signaux une troisième transformation, inverse de la première transformation susmentionnée, pour obtenir un signal s(-t) qui, en notation réelle, peut s'écrire :

$$s(-t)=A(-t)\cos[2\pi.f0.t-\varphi(-t)].$$

Dans l'exemple représenté sur la figure 1, l'ensemble modulateur 5 comporte un convertisseur analogique-digital 11 qui reçoit les signaux I(-t), -Q(-t) sous forme échantillonnée de l'unité centrale 2 et qui remet ces signaux sous forme analogique, le convertisseur 11 alimentant deux circuits parallèles d'un modulateur IQ 12 :

- un premier circuit dans lequel le signal K'1(t) I(-t) est multiplié avec un signal $\cos(2\pi.f0.t)$, le résultat de cette multiplication traversant éventuellement un filtre passe-bande 13,
- et un deuxième circuit dans lequel le signal -Q(-t) est multiplié avec un signal $\sin(2\pi. f0. t)$, le résultat de cette multiplication traversant éventuellement un filtre passe-bande 13.

Les sorties des deux filtres passe-bande 13 sont additionnées pour reconstituer le signal s(-t) qui est transmis, par exemple par l'intermédiaire d'un amplificateur 14, à l'antenne émettrice 6.

Au cours d'une ou plusieurs des première, deuxième et troisième transformations, le signal peut être multiplié par des coefficients constants ou non, de sorte que le signal d'inversion temporelle finalement obtenu peut s'écrire $\alpha.s(-t)$, $\alpha$ étant un coefficient constant ou non (dans tous les cas de figure, si $\alpha$ est un coefficient variable dans le temps, il est de préférence lentement variable par rapport à s(t)).

On notera que dans le processus de traitement des signaux, les conversions analogiques-digitales et le traitement d'inversion temporelle proprement dit sont effectués sur les signaux démodulés, ou signaux en bande de base, donc à une fréquence généralement inférieure à f0, beaucoup plus faible que la fréquence des signaux s(t) ou s(-t). On peut donc utiliser, pour effectuer ces opérations, une électronique beaucoup plus simple que celle qui serait nécessaire pour inverser temporellement directement le signal s(t) afin d'obtenir le signal d'inversion temporelle s(-t).

A titre d'exemple, la fréquence centrale f0 de l'onde électromagnétique peut être comprise entre 0,7 et 50 GHz par exemple entre 0,7 et 10 GHz. La bande passante $\Delta f$ peut être comprise par exemple entre 1 et 500 MHz, par exemple entre 1 et 5 MHz.

Bien entendu, ces valeurs de fréquences ne sont pas limitatives, et le procédé selon l'invention pourrait être utilisé pour traiter toutes sortes d'ondes électromagnétiques, y compris des ondes dont les fréquences se situeraient dans la plage des ondes optiques, notamment en remplaçant les antennes 3, 6 et les ensembles démodulateurs et modulateurs 4, 5 par des éléments équivalents fonctionnant en optique.

On notera par ailleurs que les première deuxième et troisième transformations susmentionnées pourraient être différentes de celles explicitées ci-dessus, pourvu que :

- la première transformation produise un premier ensemble de signaux transformés, comprenant au moins un premier signal transformé Ki(t) de plus faible fréquence centrale que le signal initial s(t), ledit premier ensemble de signaux transformés Ki(t) étant représentatif du signal initial s(t) : autrement dit, la première transformation abaisse la fréquence centrale du signal, sensiblement sans perte d'information par rapport au signal initial s(t),
- la deuxième transformation produise au moins un deuxième signal transformé K'i(t) sensiblement de même fréquence centrale que le premier signal transformé, ledit deuxième ensemble de signaux transformés K'i(t) étant représentatif du signal d'inversion temporelle s(-t),
- et la troisième transformation génère le signal d'inversion temporelle s(-t) à partir du deuxième ensemble de signaux transformés, cette troisième transformation pouvant avantageusement être la transformation inverse de la première transformation susmentionnée.

Comme expliqué précédemment, le signal peut être multiplié par des coefficients constants ou non au cours d'une ou plusieurs de ces transformations, auquel cas le signal final est $\alpha.s(-t)$.

Dans les cas les plus courants, la première transformation peut être une transformation de type démodulation adaptée pour éliminer le signal de porteuse de fréquence f0 et en extraire des signaux de modulation Ki(t) ou signaux en bande de base, la troisième transformation étant la modulation inverse, obtenue en modulant un signal porteur de fréquence f0 par le ou les signaux K'i(t).

Ces modulations et démodulations peuvent être une démodulation IQ et une modulation IQ comme explicité ci-dessus, mais peuvent le cas échéant être une démodulation et une modulation en amplitude et phase. Dans ce cas, la démodulation, constituant la première transformation susmentionnée, produit deux premiers signaux transformés K1(t) = A(t) et K2(t) = $\varphi$(t) correspondant respectivement à l'amplitude et à la phase du signal s(t). La deuxième transformation génère alors, à partir des signaux K1(t) et K2(t), des deuxièmes signaux transformés K'1(t) = A(-t) et K'2(t) = $-\varphi$(-t), et la troisième transformation est une modulation inverse de ladite démodulation, produisant le signal d'inversion temporelle s(-t) par modulation d'une porteuse de fréquence f0 en amplitude et phase avec les deuxièmes signaux transformés K'1(t) et K'2(t) :

$$s(-t)=A(-t)\cos[2\pi.f0.t-\varphi(-t)].$$

Par ailleurs, les première et troisième transformations susmentionnées peuvent également être des transformations différentes d'une démodulation et d'une modulation.

Par exemple, la première transformation peut être un sous-échantillonnage du signal s(t), avec une fréquence d'échantillonnage inférieure à 2f0 mais au moins égale à $2\Delta$f, produisant un seul signal transformé K1(t) échantillonné. Dans ce cas, la deuxième transformation peut consister en une inversion temporelle qui génère un deuxième signal transformé K'1(t) = K1(-t), et la troisième transformation peut consister en un filtrage du signal K'1(t) après conversion en signal analogique, ce filtrage ayant une bande passante centrée sur la fréquence f0 et de largeur $\Delta$f.

Selon une autre variante, la première transformation peut simplement consister en un décalage en fréquence vers le bas, en bande intermédiaire, produisant un seul premier signal transformé K1(t) ayant une fréquence centrale supérieure à $\Delta$f/2, auquel cas la deuxième transformation est une inversion temporelle transformant le signal K1(t) en K'1(t) = K1(-t), et la troisième transformation est un décalage en fréquence vers le haut, inverse dudit décalage en fréquence vers le bas appliqué initialement au signal s(t).

Par ailleurs, on notera que l'onde électromagnétique correspondant au signal d'inversion temporelle s(-t) n'est pas forcément réémise immédiatement après que l'onde s(t) a été reçue par l'antenne 3. Au contraire, le signal s(-t), ou le ou les signaux K'i(t) représentatifs de ce signal d'inversion temporelle s(-t), peuvent être déterminés pendant une phase d'apprentissage et rester en mémoire de l'unité centrale 2 pour être réutilisés ensuite afin d'émettre une onde électromagnétique ayant des caractéristiques de focalisation spatiale et temporelle souhaitées.

Par exemple, si l'unité centrale 2, l'ensemble démodulateur 4 et l'ensemble modulateur 5 sont intégrés dans un radiotéléphone, et si des éléments similaires sont intégrés dans une base fixe appartenant par exemple à un réseau de radiotéléphonie cellulaire, on peut concevoir que, pendant ladite phase d'apprentissage, la base fixe et/ou le radiotéléphone émettent un signal prédéterminé, par exemple un signal impulsionnel, et que le dispositif (radio téléphone ou base fixe) qui reçoit ce signal mémorise le signal d'inversion temporelle s(-t) correspondant ou les deuxièmes signaux transformés K'i(t) représentatifs de ce signal d'inversion temporelle.

Dans ce cas, lorsque l'un des deux dispositifs doit envoyer un message m(t) à l'autre de ces dispositifs, il peut calculer un signal d'émission S(t) = m(t)$\otimes$s(-t) où $\otimes$ est l'opérateur convolution, et émettre une onde électromagnétique correspondant à ce signal S(t). Dans ce cas, particulièrement si le milieu ambiant est très réverbérant pour les ondes électromagnétiques, ce qui est généralement le cas notamment en milieu urbain, l'onde électromagnétique émise se focalise avec une grande précision sur le dispositif qui doit recevoir le message, et le signal capté par ce dispositif récepteur est directement le message m(t).

On peut ainsi obtenir une communication bidirectionnelle entre les deux appareils qui est extrêmement discrète, puisque les ondes électromagnétiques, du fait de leur focalisation étroite, ne sont captées efficacement que par les deux appareils. En milieu réverbérant, on augmente ainsi considérablement le débit d'ensemble d'un réseau de télécommunication radio intégrant l'ensemble de ces appareils.

Bien entendu, l'étape d'apprentissage au cours de laquelle sont déterminés les signaux K'i(t) dans les différents appareils peut être réitérée à intervalles réguliers ou non, pour tenir compte des modifications du milieu (conditions météorologiques, déplacements d'objets réfléchissant les ondes électromagnétiques tels que véhicules ou autres, etc.) et/ou des déplacements des radiotéléphones mobiles intégrés dans le réseau de télécommunication.

Par ailleurs, on notera également que les antennes émettrice 6 et réceptrice 3 peuvent être confondues et remplacées par une seule antenne, par exemple dans des applications de télécommunications.

Toutefois, ces antennes ne sont pas forcément situées au voisinage l'une de l'autre. De plus, l'antenne réceptrice 3 peut éventuellement n'être utilisée qu'au cours d'une étape d'apprentissage initiale permettant de déterminer les signaux K'i(t), par exemple lorsqu'on souhaite utiliser le procédé selon l'invention uniquement pour une communication unidirectionnelle, ou pour des applications autres que des applications de télécommunication, notamment des applications visant à détruire ou chauffer un milieu de façon très localisée en focalisant des ondes électromagnétiques au point initial où se trouvait l'antenne réceptrice 3.

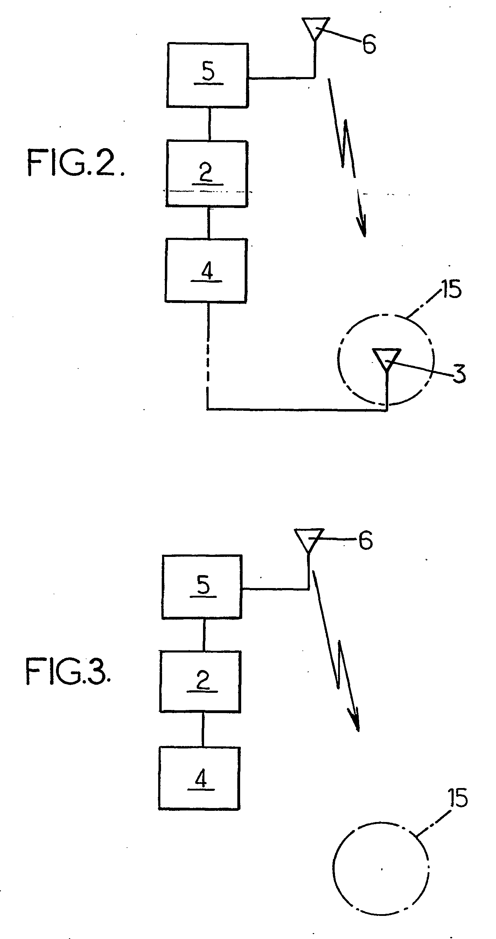

Dans ce cas, il est possible par exemple, au cours de la phase d'apprentissage, de faire émettre un signal prédéterminé S(t) par l'antenne émettrice 6, de capter l'onde électromagnétique s(t) correspondante, au moyen de l'antenne réceptrice 3, à un emplacement 15 (figure 2) où l'on souhaite focaliser les ondes électromagnétiques, puis de déterminer les signaux K'i(t) par l'une des méthodes indiquées précédemment, ce qui permet ensuite de générer, au niveau de l'antenne 6, un signal d'inversion temporelle s(-t). Lorsqu'on émet ensuite ce signal s(-t) au niveau de l'antenne émettrice 6, éventuellement après démontage de l'antenne 3 (figure 3), le signal prédéterminé (par exemple un signal impulsionnel, ou autre) initialement émis par l'antenne émettrice 6 au cours de la phase d'apprentissage, est reçu de façon très focalisée à l'emplacement 15 occupé initialement par l'antenne réceptrice 3.

Pour focaliser très précisément les ondes sur la zone 15, il est également possible d'émettre initialement le signal souhaité S(t) depuis la zone 15, puis de capter le signal correspondant s(t) au niveau de l'antenne 3, confondue avec l'antenne 6 ou très voisine de cette antenne 6. En ré-émettant ensuite le signal $\alpha$.s(-t) par l'antenne 6, on peut générer une onde S(t) focalisée très précisément sur la zone 15, le cas échéant après enlèvement de l'antenne ayant initialement émis le signal S(t).

Pour améliorer la qualité de la focalisation des ondes, il est possible d'utiliser le procédé selon l'invention en émettant et/ou en recevant les ondes par l'intermédiaire d'une cavité réverbérant les ondes électromagnétiques (ou, lorsque les ondes sont acoustiques, par l'intermédiaire d'une « cavité » au sens acoustique, constituée par exemple par un objet solide réverbérant pour les ondes acoustiques, par exemple comme décrit dans la demande de brevet français n°03 09140 déposée le 25 juillet 2003).

Par ailleurs on notera qu'une même unité centrale 2 pourrait être reliée à un réseau de plusieurs antennes 3 et 6, reliées par exemple chacune à un ensemble 4 ou 5 respectivement démodulateur ou modulateur. Par exemple, si le dispositif 1 comporte un nombre J d'antennes réceptrices 3 et un nombre L d'antennes émettrices 6, l'unité centrale 2 pour calculer J*L ensembles de signaux $K_{ijl}(t)$ qui permettent de déterminer J*L signaux d'inversion temporelle $s_{jl}(-t)$, à partir de J*L signaux initiaux $s_{jl}(t)$.

On notera également que, dans les différents modes de réalisation de l'invention, les signaux K'i(t) et/ou les signaux s(-t) correspondant à une ou plusieurs antennes peuvent être utilisés le cas échéant de façon itérative, par exemple comme indiqué dans le document WO-A-03/101302, de façon à maximiser la précision de la focalisation des ondes électromagnétiques.

Enfin, le procédé selon l'invention est applicable non seulement aux ondes électromagnétiques, mais également aux ondes acoustiques ou élastiques, en remplaçant simplement les antennes 3, 6 par des transducteurs acoustiques, en permettant des applications de communication par voie acoustique (par exemple de communication sous-marine) ou encore d'imagerie ultrasonore (échographie ou similaire, microscopie, etc.).

## Revendications

1. Procédé pour inverser temporellement une onde correspondant à au moins un signal initial s(t), où t est le temps, ce signal initial s(t) présentant une certaine fréquence centrale f0 et une bande passante $\Delta$f, procédé dans lequel on détermine un signal d'inversion temporel $\alpha$.s(-t), où $\alpha$ est un coefficient multiplicatif et s(-t) est l'inversion temporelle de s(t),
**caractérisé en ce qu'**il comporte au moins les étapes suivantes :

- on applique au signal initial s(t) une première transformation (7) adaptée pour abaisser la fréquence centrale du signal et pour sensiblement ne pas entraîner de perte d'information par rapport au signal initial, ladite première transformation produisant un premier ensemble de signaux transformés comprenant au moins un premier signal transformé Ki(t) de plus faible fréquence centrale que le signal initial, ledit premier ensemble de signaux transformés Ki(t) étant représentatif dudit signal initial s(t),

- on applique à chaque premier signal transformé Ki(t), une deuxième transformation (2) produisant un deuxième signal transformé K'i(t) sensiblement de même fréquence centrale que le premier signal transformé, ladite deuxième transformation produisant ainsi un deuxième ensemble de signaux transformés K'i(t) à partir du premier ensemble de signaux transformés Ki(t), ladite deuxième transformation étant choisie pour que ledit deuxième ensemble de signaux transformés soit représentatif du signal d'inversion temporel s(-t),
- on applique au deuxième ensemble de signaux transformés K'i(t) une troisième transformation (12) qui génère le signal d'inversion temporel $\alpha$.s(-t), la troisième transformation étant une transformation inverse de la première transformation.

2. Procédé selon la revendication 1, dans lequel la bande passante $\Delta f$ est inférieure à f0.

3. Procédé selon la revendication 1 ou revendication 2, dans lequel la troisième transformation est une transformation inverse de la première transformation.

4. Procédé selon la revendication 3, dans lequel la première transformation est une démodulation adaptée pour éliminer un signal de porteuse de fréquence f0 pour extraire ledit premier ensemble de signaux transformés Ki(t) du signal initial s(t), et la troisième transformation est une modulation d'un signal porteur de fréquence f0 par le ou les signaux K'i(t).

5. Procédé selon la revendication 4, dans lequel la première transformation est une démodulation IQ produisant deux premiers signaux transformés K1(t)=I(t) et K2(t)=Q(t) tels que s(t) = I(t)cos(2$\pi$.f0.t) + Q(t)sin (2$\pi$.f0.t), la deuxième transformation transforme le signal K1(t) en K'1(t)=I(-t) et le signal K2(t) en K'2(t)=-Q(-t), et la troisième transformation est une modulation IQ inverse de ladite démodulation.

6. Procédé selon la revendication 4, dans lequel la première transformation est une démodulation en amplitude et phase produisant deux premiers signaux transformés K1(t)=A(t), et K2(t)=$\varphi$(t), où A(t) est l'amplitude du signal s(t) et $\varphi$(t) la phase du signal s(t), la deuxième transformation transforme le signal K1(t) en K'1(t)=A(-t) et le signal K2(t) en K'2(t)=-$\varphi$(-t), et la troisième transformation est une modulation inverse de ladite démodulation, produisant le signal d'inversion temporelle s(-t)=A(-t)cos[2$\pi$.f0.t-$\varphi$(-t)].

7. Procédé selon l'une quelconque des revendications 1 à 3, dans lequel la première transformation est un sous échantillonnage, avec une fréquence d'échantillonnage inférieure à 2f0 mais au moins égale à 2$\Delta f$, produisant un seul signal transformé K1(t), la deuxième transformation est une inversion temporelle transformant le signal K1(t) en K'1(t)=K1(-t), et la troisième transformation est un filtrage de bande passante sensiblement égale à $\Delta f$ et centrée sur f0, transformant K'1(t) en s(-t).

8. Procédé selon l'une quelconque des revendications 1 à 3, dans lequel la première transformation est un décalage en fréquence vers le bas, en bande intermédiaire, produisant un seul premier signal transformé K1(t), la deuxième transformation est une inversion temporelle transformant le signal K1(t) en K'1(t)=K1(-t), et la troisième transformation est un décalage en fréquence vers le haut, inverse dudit décalage en fréquence vers le bas.

9. Procédé selon l'une quelconque des revendications précédentes, dans lequel les première et troisième transformations sont réalisées sur des signaux analogiques, chaque premier signal transformé subit un échantillonnage et la deuxième transformation est réalisée numériquement avant de convertir chaque deuxième signal transformé en signal analogique.

10. Procédé selon la revendication 9, dans lequel l'échantillonnage est réalisé à une fréquence d'échantillonnage inférieure à f0.

11. Procédé selon l'une quelconque des revendications précédentes, dans lequel l'onde est électromagnétique.

12. Procédé selon la revendication 11, dans lequel la fréquence centrale f0 est comprise entre 0,7 et 50 GHz.

13. Procédé selon la revendication 12, dans lequel la fréquence centrale f0 est comprise entre 0,7 et 10 GHz.

14. Procédé selon l'une quelconque des revendications 1 à 10, dans lequel l'onde est choisie parmi les ondes acoustiques et les ondes élastiques.

**Patentansprüche**

1. Verfahren zur zeitlichen Umkehr einer Welle, die zumindest einem ursprünglichen Signal s(t) entspricht, wo t die Zeit ist, wobei dieses ursprüngliche Signal s(t) eine gewisse Mittenfrequenz f0 und eine Bandbreite Δf aufweist, Verfahren, bei dem ein zeitliches Umkehrsignal α.s(-t) bestimmt wird, wo α ein Multiplikationskoeffizient ist und s(-t) die zeitliche Umkehr von s(t) ist,
**dadurch gekennzeichnet, dass** es zumindest die folgenden Schritte umfasst:

- man wendet auf das ursprüngliche Signal s(t) eine erste Umwandlung (7) an, die geeignet ist, die Mittenfrequenz des Signals zu senken und dazu, deutlich keinen Informationsverlust gegenüber dem ursprünglichen Signal mit sich zu führen, wobei die besagte erste Umwandlung eine erste Gruppe von umgewandelten Signalen erzeugt, die zumindest ein erstes umgewandeltes Signal Ki(t) geringerer Mittenfrequenz als das ursprüngliche Signal umfasst, wobei die besagte erste Gruppe von umgewandelten Signalen Ki(t) repräsentativ für das besagte ursprüngliche Signal s(t) ist,

- man wendet auf jedes erste umgewandelte Signal Ki(t) eine zweite Umwandlung (2) an, die ein zweites umgewandeltes Signal K'i(t) erzeugt, das deutlich die gleiche Mittenfrequenz wie das erste umgewandelte Signal hat, wobei die besagte zweite Umwandlung somit eine zweite Gruppe von umgewandelten Signalen K'i(t) ausgehend von der ersten Gruppe umgewandelter Signale Ki(t) erzeugt, wobei die besagte zweite Umwandlung gewählt wird, damit die besagte zweite Gruppe umgewandelter Signale repräsentativ für das zeitliche Umkehrsignal s(-t) ist,

- man wendet auf die zweite Gruppe von umgewandelten Signalen K'i(t) eine dritte Umwandlung (12) an, die das zeitliche Umkehrsignal α.s(-t) generiert, wobei die dritte Umwandlung eine umgekehrte Umwandlung der ersten Umwandlung ist.

2. Verfahren nach Anspruch 1, wobei die Bandbreite Δf geringer als f0 ist.

3. Verfahren nach Anspruch 1 oder Anspruch 2, wobei die dritte Umwandlung eine umgekehrte Umwandlung der ersten Umwandlung ist.

4. Verfahren nach Anspruch 3, wobei die erste Umwandlung eine geeignete Demodulation ist, um ein Trägersignal mit Frequenz f0 zu entfernen, um die besagte erste Gruppe umgewandelter Signale Ki(t) des ursprünglichen Signals s(t) zu extrahieren, und wobei die dritte Umwandlung eine Modulation eines Trägersignals mit Frequenz f0 durch das oder die Signale K'i(t) ist.

5. Verfahren nach Anspruch 4, wobei die erste Umwandlung eine IQ Demodulation ist, die zwei erste umgewandelte Signale K1(t) = I(t) und K2(t)= Q(t) erzeugt, wie s(t) = I(t)cos (2π.f0.t) + Q(t) sin(2π.f0.t), bei der zweiten Umwandlung das Signal KI(t) in K'I(t)= I(-t) und das Signal K2(t) in K'2(t)= -Q(-t) umgewandelt wird, und die dritte Umwandlung eine umgekehrte IQ Modulation der besagten Demodulation ist.

6. Verfahren nach Anspruch 4, wobei die erste Umwandlung eine Demodulation in der Amplitude und der Phase ist, die zwei erste umgewandelte Signale K1(t)= A(t) und K2(t)= φ(t) erzeugt, wo A(t) die Amplitude des Signals s(t) und φ(t) die Phase des Signals s(t) ist, bei der zweiten Umwandlung das Signal K1(t) in K'1(t)= A(-t) und das Signal K2(t) in K'2(t)= -φ(-t) umgewandelt wird, und die dritte Umwandlung eine umgekehrte Modulation der besagten Demodulation ist, die das zeitliche Umkehrsignal s(-t)= A(-t) cos [2π.f0.t-φ(-t)] erzeugt.

7. Verfahren nach einem beliebigen der vorstehenden Ansprüche 1 bis 3, wobei die erste Umwandlung eine Teilabtastung mit einer Abtastfrequenz unter 2f0, aber zumindest gleich 2Δf ist, die ein einziges umgewandeltes Signal K1(t) erzeugt, die zweite Umwandlung eine zeitliche Umkehr ist, bei der das Signal K1(t) in K'1(t)= K1(-t) umgewandelt wird, und die dritte Umwandlung eine Bandbreitenfilterung deutlich gleich Δf und auf f0 zentriert ist und K'1(t) in s(-t) umwandelt.

8. Verfahren nach einem beliebigen der vorstehenden Ansprüche 1 bis 3, wobei die erste Umwandlung eine Frequenzverschiebung nach unten im Zwischenband ist, die ein einziges erstes umgewandeltes Signal K1(t) erzeugt, die zweite Umwandlung eine zeitliche Umkehr ist, bei der das Signal K1(t) in K'1(t)= K1(-t) umgewandelt wird, und die dritte Umwandlung eine Frequenzverschiebung nach oben ist, umgekehrt zur besagten Frequenzverschiebung nach unten.

9. Verfahren nach einem beliebigen der vorstehenden Ansprüche, wobei die erste und die dritte Umwandlung auf Analogsignalen durchgeführt werden, jedes erste umgewandelte Signal eine Abtastung erfährt, und die zweite Umwandlung digital durchgeführt wird, bevor jedes zweite umgewandelte Signal in ein Analogsignal umgewandelt wird.

**10.** Verfahren nach Anspruch 9, wobei das Abtasten bei einer Abtastfrequenz unter f0 durchgeführt wird.

**11.** Verfahren nach einem beliebigen der vorstehenden Ansprüche, wobei die Welle elektromagnetisch ist.

**12.** Verfahren nach Anspruch 11, wobei die Mittenfrequenz f0 zwischen 0,7 und 50 GHz liegt.

**13.** verfahren nach Anspruch 12, wobei die Mittenfrequenz f0 zwischen 0,7 und 10 GHz liegt.

**14.** Verfahren nach einem beliebigen der vorstehenden Ansprüche 1 bis 10, wobei die Welle aus den akustischen und den elastischen Wellen gewählt wird.


**Claims**

**1.** A method for temporal inversion of a wave corresponding to at least one initial signal s(t), where t is the time, this initial signal s(t) exhibiting a certain central frequency f0 and a passband $\Delta f$, in which method a temporal inversion signal $\alpha.s(-t)$, where $\alpha$ is a multiplicative coefficient and s(-t) is the temporal inversion of s(t), is determined, **characterized in that** it comprises at least the following steps:

- a first transformation (7) suitable for lowering the central frequency of the signal and for substantially not causing any loss of information with respect to the initial signal is applied to the initial signal s(t), said first transformation producing a first set of transformed signals comprising at least one first transformed signal Ki(t) of lower central frequency than the initial signal, said first set of transformed signals Ki(t) being representative of said initial signal s(t),
- a second transformation (2) producing a second transformed signal K'i(t) substantially of the same central frequency as the first transformed signal is applied to each first transformed signal Ki(t), said second transformation thus producing a second set of transformed signals K'i(t) from the first set of transformed signals Ki(t), said second transformation being chosen so that said second set of transformed signals is representative of the temporal inversion signal s(-t),
- a third transformation (12) which generates the temporal inversion signal $\alpha.s(-t)$ is applied to the second set of transformed signals K'i(t), the third transformation being a transformation inverse to the first transformation.

**2.** The method as claimed in claim 1, in which the passband $\Delta f$ is less than f0.

**3.** The method as claimed in claim 1 or claim 2, in which the third transformation is a transformation inverse to the first transformation.

**4.** The method as claimed in claim 3, in which the first transformation is a demodulation suitable for eliminating a carrier signal of frequency f0 so as to extract said first set of transformed signals Ki(t) from the initial signal s(t), and the third transformation is a modulation of a carrier signal of frequency f0 by the signal or signals K'i(t).

**5.** The method as claimed in claim 4, in which the first transformation is an IQ demodulation producing two first transformed signals K1(t)=I(t) and K2(t)=Q(t) such that s(t) = I(t)cos(2$\pi$.f0.t) + Q(t)sin(2$\pi$.f0.t), the second transformation transforms the signal K1(t) into K'1(t)=I(-t) and the signal K2(t) into K'2(t)= -Q(-t), and the third transformation is an IQ modulation inverse to said demodulation.

**6.** The method as claimed in claim 4, in which the first transformation is an amplitude and phase demodulation producing two first transformed signals K1(t)=A(t), and K2(t)=$\varphi$(t), where A(t) is the amplitude of the signal s(t) and $\varphi$(t) the phase of the signal s(t), the second transformation transforms the signal K1(t) to K'1(t)=A(-t) and the signal K2(t) to K'2(t)=-$\varphi$(-t), and the third transformation is a modulation inverse to said demodulation, produing the temporal inversion signal s(-t)=A(-t)cos[2$\pi$.f0.t-$\varphi$(-t)].

**7.** The method as claimed in any one of claims 1 to 3, in which the first transformation is a subsampling, with a sampling frequency of less than 2f0 but at least equal to 2$\Delta f$, producing a single transformed signal K1(t), the second transformation is a temporal inversion transforming the signal K1(t) to K'1(t)=I(-t), and the third transformation is a filtering of passband substantially equal to $\Delta f$ and centered on f0, transforming K'1(t) into s(-t).

**8.** The method as claimed in any one of claims 1 to 3, in which the first transformation is a downward frequency shift,

9

into intermediate band, producing a single first transformed signal K1(t), the second transformation is a temporal inversion transforming the signal K1(t) into K'1(t)=K1(-t), and the third transformation is an upward frequency shift, the inverse of said downward frequency shift.

9. The method as claimed in any one of the preceding claims, in which the first and third transformations are carried out on analog signals, each first transformed signal undergoes a sampling and the second transformation is carried out digitally before converting each second transformed signal into an analog signal.

10. The method as claimed in claim 9, in which the sampling is carried out at a sampling frequency of below f0.

11. The method as claimed in any one of the preceding claims, in which the wave is electromagnetic.

12. The method as claimed in claim 11, in which the central frequency f0 is between 0.7 and 50 GHz.

13. The method as claimed in claim 12, in which the central frequency f0 is between 0.7 and 10 GHz.

14. The method as claimed in any one of claims 1 to 10, in which the wave is chosen from among acoustic waves and elastic waves.

FIG.1.

FIG.2.

FIG.3.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0803991 A
- US 2004014498 A
- US 2003138053 A
- FR 0309140
- WO 03101302 A